(19) Europäisches Patentamt
European Patent Office
Office européen des brevets

(11) **EP 2 174 146 B1**

(12) **EUROPÄISCHE PATENTSCHRIFT**

(45) Veröffentlichungstag und Bekanntmachung des Hinweises auf die Patenterteilung:
**25.01.2012 Patentblatt 2012/04**

(21) Anmeldenummer: **08786846.9**

(22) Anmeldetag: **04.08.2008**

(51) Int Cl.:
*G01R 15/18* (2006.01)       *G01R 15/20* (2006.01)

(86) Internationale Anmeldenummer:
**PCT/EP2008/060233**

(87) Internationale Veröffentlichungsnummer:
**WO 2009/019252 (12.02.2009 Gazette 2009/07)**

(54) **ANORDNUNG UND VERFAHREN ZUR MESSUNG EINES IN EINEM ELEKTRISCHEN LEITER FLIESSENDEN STROMS**

ARRANGEMENT AND METHOD FOR MEASURING A CURRENT FLOWING IN AN ELECTRICAL CONDUCTOR

ENSEMBLE ET PROCÉDÉ POUR LA MESURE D'UN COURANT CIRCULANT DANS UN CONDUCTEUR ÉLECTRIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **03.08.2007 DE 102007036573**

(43) Veröffentlichungstag der Anmeldung:
**14.04.2010 Patentblatt 2010/15**

(73) Patentinhaber: **Epcos AG**
**81669 München (DE)**

(72) Erfinder:
• **RÖLLGEN, Bernhard**
**81673 München (DE)**
• **NEUDECKER, Martin**
**81547 München (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A- 1 450 176        EP-A- 1 762 852**
**DE-B4-102005 024 075**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Aus der Druckschrift DE 10 2005 024 075 B4 ist eine Vorrichtung zur Messung eines in einem elektrischen Leiter fließenden Stroms bekannt. Das Dokument EP 1 762 852 zeigt eine Vorrichtung zur Messung eines in einem elektrischen Leiter fließenden Stroms. Im Luftspalt eines Magnetkreises sind zwei Steuerkerne in Serie angeordnet, die jeweils eine Steuerwicklung zur magnetischen Sättigung des jeweiligen Steuerkerns aufweisen.

Eine zu lösende Aufgabe besteht darin, eine Anordnung und ein Verfahren zur Messung eines in einem elektrischen Leiter fließenden Stroms anzugeben, welche unabhängig von äußeren magnetischen Einflüssen eine korrekte Messung ermöglichen.

Diese Aufgabe wird durch eine Anordnung zur Messung eines in einem elektrischen Leiter fließenden Stroms gemäß Anspruch 1 gelöst.

Des weiteren wird die Aufgabe durch ein Verfahren gemäß Anspruch 10 gelöst.

Die Anordnung weist einen mit einem Luftspalt versehenen Magnetkreis zur Kopplung mit einem elektrischen Leiter auf. Im Magnetkreis befindet sich ein magnetfeldsensitives Bauelement zur Messung des vom elektrischen Leiter erzeugten Magnetfeldes. Das magnetfeldsensitive Bauelement ist bevorzugt direkt in den Magnetkreis eingebaut. In dem Luftspalt des Magnetkreises befinden sich zwei Steuerkerne, wobei die Steuerkerne jeweils eine Steuerwicklung zur magnetischen Sättigung des jeweiligen Steuerkerns aufweisen und beidseitig des dazwischen liegenden elektrischen Leiters angeordnet sind.

Der Magnetkreis besteht in einer bevorzugten Ausführungsform aus einem U-förmigen weichmagnetischen Kern, in den das magnetfeldsensitive Bauelement direkt eingebaut ist. Bevorzugt befindet sich das magnetfeldsensitive Bauelement mittig zwischen den beiden Armen des U-förmigen Kerns.

Die beiden Steuerkerne können unabhängig voneinander durch darauf aufgebrachte Wicklungen mittels Steuerströmen gesättigt werden.

Ein erster Steuerkern befindet sich auf einer ersten Seite des elektrischen Leiters und ein zweiter Steuerkern befindet sich auf einer zweiten Seite des elektrischen Leiters.

Der zweite Steuerkern befindet sich vorzugsweise parallel zu dem magnetfeldsensitiven Bauelement zwischen den beiden Armen des bevorzugt U-förmigen Magnetkreises.

In einer Ausführungsform weist der Magnetkreis eine zusätzliche Wicklung auf.

In einer bevorzugten Ausführungsform liegen die beiden Steuerkerne in einer gemeinsamen Ebene. Die beiden Steuerkerne sind bevorzugt zwischen den beiden Armen des U-förmigen Kerns, beidseitig des elektrischen Leiters, angeordnet.

Vorzugsweise wird der elektrische Leiter vom Magnetkreis umgriffen.

In einer bevorzugten Ausführungsform sind die Steuerkerne als Ferritkerne ausgebildet. Dabei sind die Ferritkerne besonders bevorzugt als rechteckiger Rahmen ausgebildet, der auf mindestens einer Seite des Rahmens eine Steuerwicklung zur Sättigung des Ferritkerns aufweist. In einer besonders effizienten Variante sind Steuerwicklungen auf zwei gegenüberliegenden Seiten des Rahmens angeordnet. Durch die Ausbildung der Steuerkerne in dieser Form kann eine effiziente Sättigung der Steuerkerne erreicht werden.

Dadurch, dass in dem Magnetkreis die beiden Steuerkerne nicht hintereinander, sondern parallel zueinander angeordnet sind, also beidseitig des elektrischen Leiters, können diese, im Vergleich zu einem Aufbau mit zwei übereinander angeordneten Steuerkernen, mehr als die doppelte Anzahl Windungen auf den Steuerkernen aufweisen. Bei gleichem Drahtdurchmesser der Steuerwicklungen stehen somit die doppelte Anzahl an Windungen zur Verfügung. Dies ermöglicht die Messung sehr großer Ströme, ohne dass die Steuerkerne vom Primärstrom aus der Sättigung getrieben werden. Bei sehr großen Strömen, die im Bereich von ca. 1000A liegen, würde der Primärstrom dem Steuerstrom in einem der Schenkel der Steuerkerne entgegenwirken und diese so aus der Sättigung treiben.

Das magnetfeldsensitive Bauelement ist bevorzugt ein Hall-Sensor.

Wird ein Hall-Sensor von einem Strom durchflossen und ist in ein senkrecht dazu verlaufendes Magnetfeld gebracht, liefert er eine Ausgangsspannung, die proportional zum Produkt aus magnetischer Feldstärke und Strom ist.

Zur Bestimmung des in dem elektrischen Leiter fließenden Stroms werden verschiedene Messungen mit Hilfe des Hall-Sensors durchgeführt.

Das Verfahren zur Messung eines in einem elektrischen Leiter fließenden Stroms wird mit einer wie oben beschriebenen Anordnung durchgeführt.

Bei dem Verfahren wird die das magnetfeldsensitive Bauelement durchsetzende Flussdichte zuerst bei ungesättigten Steuerkernen gemessen.

Bei einer zweiten Messung wird der erste Steuerkern gesättigt, der zweite Steuerkern bleibt ungesättigt, wobei die das magnetfeldsensitive Bauelement durchsetzende Flussdichte gemessen wird.

Für eine dritte Messung wird der zweite Steuerkern gesättigt, der erste Steuerkern ist ungesättigt. Die das magnetfeldsensitive Bauelement durchsetzende Flussdichte ergibt einen dritten Messwert.

Für eine vierte und letzte Messung wird die das magnetfeldsensitive Bauelement durchsetzende Flussdichte bei Sättigung beider Steuerkerne gemessen.

Aus den vier Messwerten, die durch die zuvor durchgeführten Messungen ermittelt wurden, wird der durch den elektrischen Leiter fließende Strom berechnet.

Für Ströme die kleiner als 50A sind, weisen die erste und dritte Messung in etwa die gleiche Stromempfindlichkeit auf. Bei der ersten ist der zweite Steuerkern ungesättigt und bei der dritten Messung gesättigt. An dem magnetfeldsensitiven Bauelement liegt bei beiden Messungen somit das gleiche H-Feld an. Das H-Feld wirkt somit auf das magnetfeldsensitive Bauelement analog wie eine anliegende Spannung. Die magnetischen Widerstände des Magnetkreises und der Steuerkerne wirken analog zu elektrischen Widerständen.

Es gelten somit folgende drei Gleichungen:

$$I. \quad r_4 = n + s_4 * I_{DC} + S_{B4} * B_S$$

$$II. \quad r_3 = n + s_3 * I_{DC} + S_{B3} * B_S$$

$$III. \quad r_2 = n + s_2 * I_{DC} + S_{B2} * B_S$$

In der Messung werden physikalische Größen oft in analoge elektrische Größen umgewandelt. Bei der Quantisierung wird der Messbereich der analogen Größe in eine endliche Zahl aneinander angrenzender Teilbereiche (Intervalle) aufgeteilt und jedem davon ein Wert eines endlichen symbolischen Systems zugeordnet (z.B. eine ganze Zahl). Als Auflösung wird die Anzahl der verwendeten Teilbereiche der analogen Größe, bei binären symbolischen Systemen auch ihre Zweierpotenz (Auflösung in Bit) bezeichnet, jedoch bei gleich großen Intervallen auch die Größe der Intervalle selbst.

Die Quantisierungsschritte geben den Wert für das Messsignal in diskreter Form wieder.

In den oben angeführten Gleichungen gibt $r_2$ die Anzahl der Quantisierungsschritte bei einer Messung, bei Sättigung des ersten Steuerkerns an. $r_3$ gibt die Anzahl bei Sättigung des zweiten Steuerkerns wieder. $r_4$ gibt die Anzahl der Quantisierungsschritte an, bei der beide Steuerkerne gesättigt sind. Die Variablen $s_2$, $s_3$ und $s_4$ geben die jeweilige Empfindlichkeit des Hallsensors gegenüber dem durch den elektrischen Leiter fließenden Strom an.

Die Variable n gibt den Nullpunkt des magnetfeldsensitiven Bauelements in Quantisierungsschritten an, bei dem im elektrischen Leiter 0A Strom und am magnetfeldsensitiven Bauelement 0 Tesla Flussdichte anliegen. Die Variablen $S_{B2}$, $S_{B3}$ und $S_{B4}$ geben die Sensitivität des magnetfeldsensitiven Bauelements bei Sättigung des ersten Steuerkerns, bei Sättigung des zweiten Steuerkerns beziehungsweise bei Sättigung beider Steuerkerne an. Die Variable $B_S$ bezeichnet die magnetische Flussdichte eines störenden externen Magnetfeldes. Die Variable $I_{DC}$ gibt den durch den elektrischen Leiter fließenden Strom an, der in der Messung ermittelt werden soll.

Sämtliche Empfindlichkeiten werden während der Produktion der Anordnung bestimmt und in der Auswerteeinheit fest hinterlegt.

Anschließende Eliminierung von n liefert:

$$I-II \quad r_4 - r_3 = (s_4 - s_3) * I_{DC} + (S_{B4} - S_{B3}) * B_S$$

$$I-III \quad r_4 - r_2 = (s_4 - s_2) * I_{DC} + (S_{B4} - S_{B2}) * B_S$$

Die beiden Gleichungen I-II und I-III werden nach $I_{DC}$ aufgelöst, anschließend gleichgesetzt und weiter nach $B_S$ aufgelöst:

$$B_S = r_3*(s_2 - s_4) + r_4*(s_3 - s_2) + r_2*(s_4 - s_3) \ /$$

$$(s_{B4}*(s_3 - s_2) + s_{B3}*(s_2 - s_4) + s_{B2}*(s_4 - s_3))$$

Zur Bestimmung von $I_{DC}$ und n kann durch Einsetzen von $B_S$ in die Gleichungen I-II oder I-III und danach durch Einsetzen von $I_{DC}$ und $B_S$ in eine der Gleichungen I bis III aufgelöst werden. Durch Auflösen nach Gleichung III kann n bestimmt werden, durch Auflösen nach Gleichung II kann $I_{DC}$. Die Gleichung I ist für die Bestimmung von $B_S$ am besten geeignet.

$B_S$ kann alternativ auch in Gleichung II oder III vernachlässigt werden. Der leicht ungenau bestimmte Primärstrom $I_{DC}$ kann, falls erforderlich, zur Ermittlung von $B_S$ herangezogen werden.

Es ist bekannt, dass Hallsensoren aus mehreren Gründen driften können, wobei einige dieser im Folgenden näher beschrieben werden.

Die Hallzelle wird bei monolithischem Aufbau vorzugsweise als schwach dotiertes Diffusionsgebiet im Siliziumsubstrat oder einer Epi-Schicht ausgeführt. Eine leitfähige Platte wird vorzugsweise darüber aufgebracht, damit das Schrotrauschen verringert wird. Das schwach dotierte Diffusionsgebiet bildet eine parasitäre Diode, die in Rückwärtsrichtung vorgespannt werden muss. Es tritt der so genannte "Back-bias-Effekt" auf, eine Wanderbewegung der Raumladungszonen (analog zu Kapazitätsdioden). Die Dickenmodulation der Raumladungszone wirkt sich direkt auf die Sensitivität der Hallzelle aus (ca. +3 .. 5 %/V). Die leitfähige Platte über der Hallzelle wird meist ebenfalls mit einer Vorspannung beaufschlagt. Diese Vorspannung bewirkt ebenfalls eine Dickenmodulation der Raumladungszone des schwach dotierten Diffusionsgebiets (0.01%/V). Driften die Vorspannungen, z.B. durch Alterung, so driftet auch die Empfindlichkeit der Hallzelle.

Des Weiteren weisen Hallelemente eine starke Empfindlichkeit für den piezoresistiven Effekt auf. Mechanische Verformungen durch äußeren Druck oder durch Wasseraufnahme verändern die Empfindlichkeit der Hallzelle. Überzieht man den Siliziumchip mit einem weichen Kunststoff bevor das Gehäuse gespritzt wird, so lässt sich die Langzeitdrift der Sensitivität auf 0.25% senken. Mechanische Verformungen treten bereits nach wenigen Betriebsstunden auf (10 .. 100h), sind in manchen Fällen reversibel und haben meist den größten Anteil an der Langzeitdrift.

Intersitielle Diffusion von Verunreinigungen, z.B. von schwach gebundenem Wasserstoff, ist für die Widerstandsdrift von diffundierten Widerständen in Halbleitern bekannt. Die Langzeitdrift kann 1% /100000 Stunden betragen.

n+ dotierte Diffusionsgebiete von 130nm BICMOS-Prozessen weisen einen Temperaturkoeffizient von ca. 1500 .. 2000 ppm/K auf. Moderne Hallsensoren kompensieren die Temperaturdrift durch Messung der Sperrschichttemperatur und durch Errechnung eines temperaturkompensierten Messwerts.

Der in der Anordnung verwendete Hall-Sensor weist eine Alterung der Sensitivität auf. Die in den Gleichungen verwendeten Empfindlichkeiten des Hall-Sensors ($S_{B2}$, $S_{B3}$ und $S_{B4}$) sind ausschließlich vom mechanischen Aufbau abhängig. Wenn die Mechanik sich nicht verändern kann, beispielsweise durch Vollverguss, können sich die Empfindlichkeiten lediglich verändern, wenn der Magnetfeldsensor mit der Zeit selbst empfindlicher oder unempfindlicher wird. Es bietet sich dadurch die Möglichkeit, die Alterung der Empfindlichkeit des Magnetfeldsensors zu bestimmen, indem nun durch Lösen des Gleichungssystems aus insgesamt vier Gleichungen nach der Sensitivität des Hallsensors aufgelöst wird. Um eine genauere Messung zu ermöglichen, kann die Empfindlichkeit des Hallsensors als gemeinsamer Faktor aller Empfindlichkeiten dargestellt werden und die Empfindlichkeit des Hallsensors $s_{hall}$ kann mittels folgender Gleichung berechnet werden.

$$r_x = n + s_{hall} \ (I * s_x + B * s_{Bx})$$

In der oben angegebenen Gleichung gibt $r_X$ die Anzahl der Quantisierungsschritte für den jeweiligen Zustand x an. Die Variable x steht für einen der vier Fälle (x = 1 .. 4). Im ersten Fall sind beide Steuerkerne ungesättigt, im zweiten Fall ist nur der erste Steuerkern gesättigt, im dritten Fall ist nur der zweite Steuerkern gesättigt und im vierten Fall sind beide Steuerkerne gesättigt. Die Variable n gibt den Nullpunkt des magnetfeldsensitiven Bauelements in Quantisierungsschritten an, bei dem im elektrischen Leiter 0A Strom und am magnetfeldsensitiven Bauelement 0 Tesla Flussdichte anliegen. Die Variable $S_{Bx}$ gibt die Sensitivität des magnetfeldsensitiven Bauelements für den entsprechenden Zustand an. Die Variable B bezeichnet die magnetische Flussdichte eines störenden externen Magnetfeldes.

Somit kann die Sensitivität $s_{hall}$ des magnetfeldsensitiven Bauelements aus den zuvor erhaltenen Messwerten berechnet werden.

Die Anordnung wird im Folgenden anhand von Ausführungsbeispielen und den dazugehörigen Figuren näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.
Elemente, die einander gleichen oder die die gleiche Funktion übernehmen, sind mit gleichen Bezugszeichen bezeichnet.

Figur 1     zeigt eine beispielhafte Anordnung zur Messung eines in einem elektrischen Leiter fließenden Stroms.

Figur 2     zeigt den ersten Aufbau zur Messung eines in einem elektrischen Leiter fließenden Stroms bei ungesättigten Steuerkernen.

Figur 3     zeigt den zweiten Aufbau zur Messung eines in einem elektrischen Leiter fließenden Stroms bei Sättigung des ersten Steuerkerns.

Figur 4     zeigt den dritten Aufbau zur Messung eines in einem elektrischen Leiter fließenden Stroms bei Sättigung des zweiten Steuerkerns.

Figur 5     zeigt den vierten Aufbau zur Messung eines in einem elektrischen Leiter fließenden Stroms bei Sättigung beider Steuerkerne.

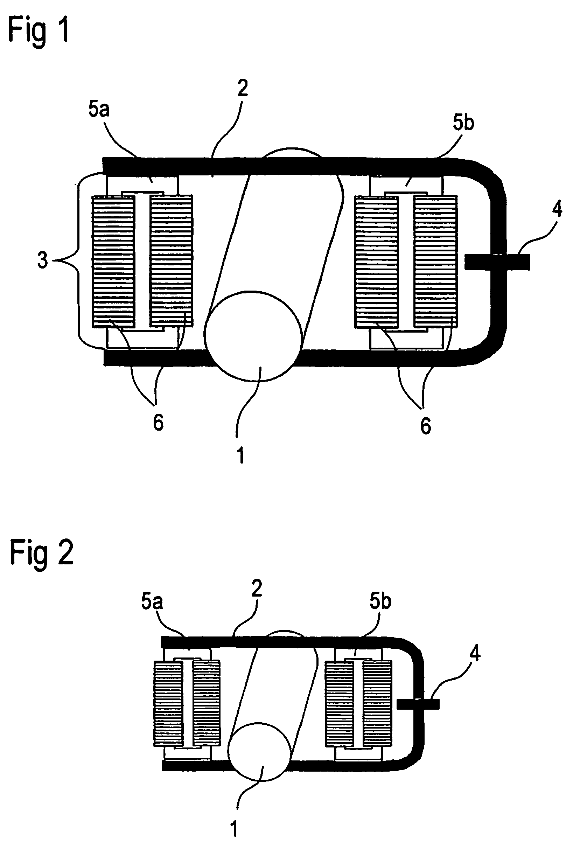

In Figur 1 ist eine mögliche Variante der beispielhaften Anordnung zur Messung eines in einem elektrischen Leiter 1 fließenden Stroms gezeigt, bei der ein Magnetkreis 2, der aus Ferrit bestehen kann, einen elektrischen Leiter 1 umgreift. Der Magnetkreis 2 weist auf einer Seite einen Luftspalt 3 auf, in dem sich zwei Steuerkerne 5a, 5b befinden. Die Steuerkerne 5a, 5b sind bevorzugt beidseitig des elektrischen Leiters 1 angeordnet. Der zweite Steuerkern 5b ist dabei in der Nähe des magnetfeldsensitiven Bauelements 4, vorzugsweise parallel zu diesem, angeordnet. Im U-förmigen Magnetkreis 2 befindet sich bevorzugt zwischen den Armen des Magnetkreises 2 ein magnetfeldsensitives Bauelement 4, das zur Messung des in dem elektrischen Leiter 1 fließenden Stroms dient. Die Steuerkerne 5a, 5b weisen jeweils Steuerwicklungen 6 auf, die zur Sättigung der Steuerkerne 5a, 5b dienen. Diese Steuerwicklungen 6 befinden sich bevorzugt auf einer oder mehreren, bevorzugt gegenüberliegenden Seiten des Rahmens des Steuerkerns 5a, 5b.
Figur 2 zeigt den ersten Messaufbau zur Messung des durch den elektrischen Leiter 1 fließenden Stroms. Die Steuerkerne 5a, 5b sind bevorzugt beidseitig des elektrischen Leiters 1 angeordnet. Bei der ersten Messung sind beide Steuerkerne 5a, 5b ungesättigt. Das magnetfeldsensitive Bauelement 4, das zwischen den Armen des U-förmigen Magnetkreises 2 angeordnet ist, misst den durch den elektrischen Leiter 1 fließenden Strom.
Das vom Stromfluss durch den elektrischen Leiter 1 hervorgerufene H-Feld erzeugt ein B-Feld in den beiden Armen des U-förmigen Magnetkreises 2 und in den Steuerkernen 5a, 5b. Wenn der magnetische Widerstand des ersten Steuerkerns 5a nicht signifikant kleiner als der magnetische Widerstand des Magnetkreises 2 und des zweiten Steuerkerns 5b ist, so wird das magnetfeldsensitive Bauelement 4 von nahezu genauso viel B-Feld durchflutet, als wenn der zweite Steuerkern 5b nicht vorhanden oder gesättigt wäre. Die Stromempfindlichkeit des Aufbaus ist dadurch sehr hoch. Der gesamte magnetische Kreis 2 ist durch die Steuerkerne 5a, 5b geschlossen, wodurch die Empfindlichkeit für störende äußere Magnetfelder gering ist. Zum genauen Messen kleiner Ströme bei bekanntem Nullpunkt und bei bekanntem störenden äußerem Magnetfeld muss kein Steuerkern 5a, 5b bestromt werden. Das magnetfeldsensitive Bauelement 4 ist in diesem Fall weiterhin in der Lage, das B-Feld zu messen.

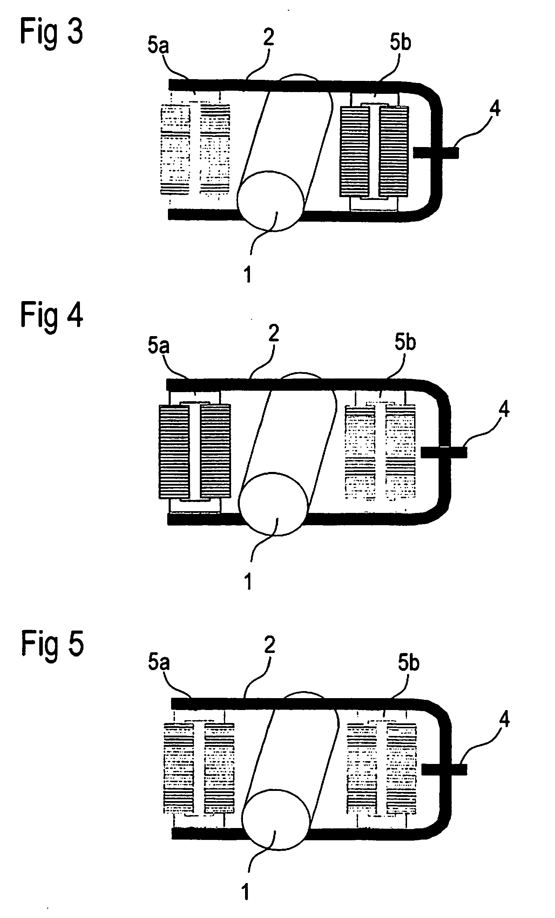

In Figur 3 ist der zweite Aufbau zur Messung des durch den elektrischen Leiter 1 fließenden Stroms gezeigt. Für die zweite Messung des durch das magnetfeldsensitive Bauelement 4 fließenden Strom, wird der erste Steuerkern 5a gesättigt. Der zweite Steuerkern 5b bleibt ungesättigt.
Der magnetische Widerstand des ersten Steuerkerns 5a erhöht sich derart stark, dass nahezu kein magnetischer Fluss (B-Feld) im magnetfeldsensitiven Bauelement 4 registriert werden kann, da der magnetische Widerstand des zweiten Steuerkerns 5b in diesem Fall wesentlich kleiner ist, als der im Magnetkreis 2 wirksame magnetische Widerstand. Die Empfindlichkeit auf störende äußere Magnetfelder ist gering, weil der überwiegende Anteil der den Aufbau durchfließenden Feldlinien durch den magnetisch gut leitfähigen zweiten Steuerkern 5b fließt.
Die Figur 4 zeigt einen dritten Aufbau bei dem der durch den elektrischen Leiter 1 fließenden Stroms mittels des magnetfeldsensitiven Bauelements 4 gemessen wird. Für die dritte Messung wird der zweite Steuerkern 5b gesättigt. Der erste Steuerkern 5a ist ungesättigt.
In diesem Aufbau ist der magnetische Widerstand des ersten Steuerkerns 5a niedrig, jedoch der magnetische Widerstand des zweiten Steuerkerns 5b hoch, so dass der Aufbau wieder magnetisch geschlossen ist. Das magnetfeldsensitive Bauelement 4 wird von geringfügig mehr Feldlinien durchflossen als bei der ersten Messung, die in Figur 2 dargestellt ist.
In Figur 5 ist der vierte Aufbau zur Messung des durch den elektrischen Leiter 1 fließenden Stroms gezeigt. Für die vierte Messung werden beide Steuerkerne 5a, 5b gesättigt. In diesem Aufbau ist der magnetische Kreis offen.

Nahezu alle Feldlinien führen durch den Luftspalt 3 im U-förmigen Magnetkreis 2, in dem sich das magnetfeldsensitive Bauelement 4 befindet. Äußere Störfelder sowie das Magnetfeld, das durch den Strom erzeugt wird, der durch den elektrischen Leiter 1 fließt, werden vom magnetfeldsensitiven Bauelement 4 mit hoher Sensitivität erfasst. Die Empfindlichkeit für den durch den elektrischen Leiter 1 fließenden Strom ist etwa eine Zehnerpotenz geringer als in den in Figur 2 und 4 dargestellten Messungen und sie ist etwa eine Zehnerpotenz größer als bei der in Figur 3 dargestellten Messung. Die Empfindlichkeit für störende äußere Magnetfelder kann jedoch um mehr als eine Zehnerpotenz größer sein als in den anderen drei Messungen.

Obwohl in den Ausführungsbeispielen nur eine beschränkte Anzahl möglicher Weiterbildungen der Erfindung beschrieben werden konnte, ist die Erfindung nicht auf diese beschränkt. Es ist prinzipiell möglich, eine andere Anzahl der Steuerwicklungen oder eine andere Form des Magnetkreises für die Anordnung zu verwenden. Die Erfindung ist nicht auf die Anzahl der schematisch dargestellten Elemente beschränkt.

Die Beschreibung der hier angegebenen Gegenstände und Verfahren ist nicht auf die einzelnen speziellen Ausführungsformen beschränkt. Vielmehr können die Merkmale der einzelnen Ausführungsformen - soweit technisch sinnvoll - beliebig miteinander kombiniert werden.

Bezugszeichenliste

1    elektrischer Leiter

2    Magnetkreis

3    Luftspalt

4    magnetfeldsensitives Bauelement

5a    erster Steuerkern

5b    zweiter Steuerkern

6    Steuerwicklung

**Patentansprüche**

**1.** Anordnung zur Messung eines in einem elektrischen Leiter (1) fließenden Stroms, aufweisend

- einen Magnetkreis (2) mit Luftspalt (3) zur Kopplung mit dem elektrischen Leiter (1),
- ein im Magnetkreis (2) angeordnetes magnetfeldsensitives Bauelement (4) zur Messung des vom elektrischen Leiter (1) erzeugten Magnetfelds,
- zwei Steuerkerne (5a, 5b), **dadurch gekennzeichnet, dass**

die Steuerkerne (5a, 5b) jeweils eine Steuerwicklung (6) zur magnetischen Sättigung des jeweiligen Steuerkerns (5a, 5b) aufweisen und in dem Luftspalt (3) beidseitig des dazwischen liegenden elektrischen Leiters (1) angeordnet sind.

**2.** Anordnung nach Anspruch 1, bei der ein erster Steuerkern (5a) auf einer ersten Seite des elektrischen Leiters (1) angeordnet ist und ein zweiter Steuerkern (5b) auf einer zweiten Seite des elektrischen Leiters (1) angeordnet ist.

**3.** Anordnung nach einem der vorhergehenden Ansprüche, bei der der zweite Steuerkern (5b) parallel zu dem magnetfeldsensitiven Bauelement (4) angeordnet ist.

**4.** Anordnung nach einem der vorhergehenden Ansprüche, bei der der Magnetkreis (2) eine Zusatzwicklung aufweist.

**5.** Anordnung nach einem der vorhergehenden Ansprüche, bei der die beiden Steuerkerne (5a, 5b) in einer gemeinsamen Ebene liegen.

**6.** Anordnung nach einem der vorhergehenden Ansprüche, bei der der Magnetkreis (2) den elektrischen Leiter (1) umgreift.

**7.** Anordnung nach einem der vorhergehenden Ansprüche, bei der die Steuerkerne (5a, 5b) als Ferritkerne ausgebildet sind.

**8.** Anordnung nach einem der vorhergehenden Ansprüche, bei der die Steuerkerne (5a, 5b) einen rechteckigen Rahmen aufweisen und auf mindestens einer Seite des Rahmens eine Steuerwicklung (6) zur Sättigung der Steuerkerne (5a, 5b) aufweisen.

**9.** Anordnung nach einem der vorhergehenden Ansprüche, bei der die Steuerkerne (5a, 5b) jeweils auf zwei gegenüberliegenden Seiten eine Steuerwicklung (6) aufweisen.

**10.** Verfahren zur Messung eines in einem elektrischen Leiter (1) fließenden Stroms, bei dem die durch das magnetfeldsensitive Bauelement (4) durchsetzende Flussdichte bei ungesättigten Steuerkernen (5a, 5b) gemessen wird unter Verwendung einer Anordnung zur Messung eines in einem elektrischen Leiter (1) fließenden Stroms gemäß einem der vorhergehenden Ansprüche.

**11.** Verfahren nach Anspruch 10, bei dem die durch das magnetfeldsensitive Bauelement (4) durchsetzende Flussdichte bei Sättigung eines ersten Steuerkerns (5a) gemessen wird.

**12.** Verfahren nach Anspruch 11, bei dem die durch das magnetfeldsensitive Bauelement (4) durchsetzende Flussdichte bei Sättigung eines zweiten Steuerkerns (5b) gemessen wird.

**13.** Verfahren nach Anspruch 12, bei dem die durch das magnetfeldsensitive Bauelement (4) durchsetzende Flussdichte bei Sättigung beider Steuerkerne (5a, 5b) gemessen wird.

**14.** Verfahren nach Anspruch 13, bei dem aus den erhaltenen Messwerten der durch den elektrischen Leiter (1) fließende Strom berechnet wird.

**15.** verfahren nach Anspruch 14, bei dem die Sensitivität des magnetfeldsensitiven Bauelements (4) aus den erhaltenen Messwerten berechnet wird.

**Claims**

**1.** Arrangement for measuring a current flowing in an electrical conductor (1), comprising

  - a magnetic circuit (2) with air gap (3) for coupling to the electrical conductor (1),
  - a magnetic field-sensitive component (4) arranged in the magnetic circuit (2) and serving for measuring the magnetic field generated by the electrical conductor (1),
  - two control cores (5a, 5b),

**characterized in that** the control cores (5a, 5b) each comprise a control winding (6) for magnetically saturating the respective control core (5a, 5b) and are arranged in the air gap (3) on both sides of the electrical conductor (1) lying in between.

**2.** Arrangement according to Claim 1, wherein a first control core (5a) is arranged on a first side of the electrical conductor (1) and a second control core (5b) is arranged on a second side of the electrical conductor (1).

**3.** Arrangement according to either of the preceding claims, wherein the second control core (5b) is arranged parallel to the magnetic field-sensitive component (4).

**4.** Arrangement according to any of the preceding claims, wherein the magnetic circuit (2) comprises an additional winding.

**5.** Arrangement according to any of the preceding claims, wherein the two control cores (5a, 5b) lie in a common plane.

**6.** Arrangement according to any of the preceding claims, wherein the magnetic circuit (2) extends around the electrical conductor (1).

**7.** Arrangement according to any of the preceding claims, wherein the control cores (5a, 5b) are embodied as ferrite cores.

**8.** Arrangement according to any of the preceding claims, wherein the control cores (5a, 5b) comprise a rectangular frame and comprise a control winding (6) on at least one side of the frame for saturating the control cores (5a, 5b).

**9.** Arrangement according to any of the preceding claims, wherein the control cores (5a, 5b) comprise a control winding (6) in each case on two opposite sides.

**10.** Method for measuring a current flowing in an electrical conductor (1), wherein the flux density permeating the magnetic field-sensitive component (4) is measured in the case of unsaturated control cores (5a, 5b) using an arrangement for measuring a current flowing in an electrical conductor (1) according to any of the preceding claims.

**11.** Method according to Claim 10, wherein the flux density permeating the magnetic field-sensitive component (4) is measured in the case of saturation of a first control core (5a).

**12.** Method according to Claim 11, wherein the flux density permeating the magnetic field-sensitive component (4) is measured in the case of saturation of a second control core (5b).

**13.** Method according to Claim 12, wherein the flux density permeating the magnetic field-sensitive component (4) is measured in the case of saturation of both control cores (5a, 5b).

**14.** Method according to Claim 13, wherein the current flowing through the electrical conductor (1) is calculated from the measured values obtained.

**15.** Method according to Claim 14, wherein the sensitivity of the magnetic field-sensitive component (4) is calculated from the measured values obtained.


**Revendications**

**1.** Arrangement pour mesurer un courant qui circule dans un conducteur électrique (1), présentant

- un circuit magnétique (2) avec un entrefer (3) pour le couplage avec le conducteur électrique (1),
- un composant (4) sensible aux champs magnétiques disposé dans le circuit magnétique (2) pour mesurer le champ magnétique produit par le conducteur électrique (1),
- deux noyaux de commande (5a, 5b), **caractérisé en ce que**

les noyaux de commande (5a, 5b) présentent respectivement un enroulement de commande (6) pour la saturation magnétique du noyau de commande (5a, 5b) correspondant et sont disposés dans l'entrefer (3) des deux côtés du conducteur électrique (1) qui se trouve entre eux.

**2.** Arrangement selon la revendication 1, dans lequel un premier noyau de commande (5a) est disposé sur un premier côté du conducteur électrique (1) et un deuxième noyau de commande (5b) est disposé sur un deuxième côté du conducteur électrique (1).

**3.** Arrangement selon l'une des revendications précédentes, dans lequel le deuxième noyau de commande (5b) est disposé parallèlement au composant (4) sensible aux champs magnétiques.

**4.** Arrangement selon l'une des revendications précédentes, dans lequel le circuit magnétique (2) présente un enroulement supplémentaire.

**5.** Arrangement selon l'une des revendications précédentes, dans lequel les deux noyaux de commande (5a, 5b) se trouvent dans un plan commun.

**6.** Arrangement selon l'une des revendications précédentes, dans lequel le circuit magnétique (2) entoure le conducteur électrique (1).

**7.** Arrangement selon l'une des revendications précédentes, dans lequel les noyaux de commande (5a, 5b) sont réalisés sous la forme de noyaux en ferrite.

**8.** Arrangement selon l'une des revendications précédentes, dans lequel les noyaux de commande (5a, 5b) présentent un cadre rectangulaire et présentent sur au moins un côté du cadre un enroulement de commande (6) pour la saturation des noyaux de commande (5a, 5b).

**9.** Arrangement selon l'une des revendications précédentes, dans lequel les noyaux de commande (5a, 5b) présentent un enroulement de commande (6) à chaque fois sur deux côtés opposés.

**10.** Procédé pour mesurer un courant qui circule dans un conducteur électrique (1), selon lequel la densité de flux transféré à travers le composant (4) sensible aux champs magnétiques lorsque les noyaux de commande (5a, 5b) ne sont pas saturés est mesurée en utilisant un arrangement pour mesurer un courant qui circule dans un conducteur électrique (1) selon l'une des revendications précédentes.

**11.** Procédé selon la revendication 10, selon lequel la densité de flux transféré à travers le composant (4) sensible aux champs magnétiques lorsqu'un premier noyau de commande (5a) est saturé est mesurée.

**12.** Procédé selon la revendication 11, selon lequel la densité de flux transféré à travers le composant (4) sensible aux champs magnétiques lorsqu'un deuxième noyau de commande (5b) est saturé est mesurée.

**13.** Procédé selon la revendication 12, selon lequel la densité de flux transféré à travers le composant (4) sensible aux champs magnétiques lorsque les deux noyaux de commande (5a, 5b) sont saturés est mesurée.

**14.** Procédé selon la revendication 13, selon lequel le courant qui circule à travers le conducteur électrique (1) est calculé à partir des valeurs de mesure obtenues.

**15.** Procédé selon la revendication 14, selon lequel la sensibilité du composant (4) sensible aux champs magnétiques est calculée à partir des valeurs de mesure obtenues.

Fig 1

Fig 2

Fig 3

Fig 4

Fig 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005024075 B4
- EP 1762852 A